# EUROPEAN PATENT APPLICATION

(11) **EP 1 670 042 A1**
(43) Date of publication of application: **14.06.2006**
(21) Application number: 04788326.9
(22) Date of filing: 29.09.2004
(51) Int. Cl.: H01L 21/027, G03F 7/20, G02B 13/24

(54) **LIQUID IMMERSION TYPE LENS SYSTEM AND PROJECTION ALIGNER, DEVICE PRODUCTION METHOD**

(30) Priority: 29.09.2003 JP 2003337087
(71) Applicant: NIKON CORPORATION, Tokyo 100-8331 (JP)
(72) Inventor: OKADA, Noriaki c/o Nikon Corporation, Tokyo (JP)
(74) Representative: HOFFMANN EITLE
(86) International application number: PCT/JP2004/014260
(87) International publication number: WO 2005/031823

(57) **Abstract**

The present invention provides a high performance liquid immersion type lens system that can be stably used over a long time period and a projection exposure apparatus provided therewith. Consequently, the liquid immersion type lens system of the present invention includes: an optical system main body 30 that has an optical surface 33a at one end along an optical axis, the optical surface 33a contacting a first immersion liquid IL1; a light transmitting member 42 that has two surfaces, one on each end along the optical axis, is disposed opposing the optical surface 33a of the optical system main body 30, one 42a of the two surfaces contacting the first immersion liquid IL1, the other 42b of the two surfaces contacting a second immersion liquid IL2; and a holding member 41 that detachably supports the light transmitting member 42 so that the one surface 42a opposes the optical surface 33a of the optical system main body 30. In addition, the projection exposure apparatus of the present invention includes such a liquid immersion type lens system.

## Description

Priority is claimed on Japanese Patent Application No. 2003-337087 (filed September 29, 2003), the contents of which are incorporated herein by reference.

### TECHNICAL FIELD

The present invention relates to a lens system, which is incorporated in a projection exposure apparatus and the like, for transferring a mask pattern onto a photosensitive substrate in a lithographic process in order to fabricate devices, such as semiconductor devices, and more particularly relates to a liquid immersion type lens system, a projection exposure apparatus that incorporates the lens system, and a device fabricating method that uses the liquid immersion type projection exposure apparatus.

### BACKGROUND ART

Ultraviolet laser light, which has a wavelength shorter than visible light, is used as the exposure light in projection exposure apparatuses for the purpose of increasing the exposure resolution. Projection exposure apparatuses of this type that have been commercialized include one that uses the currently mainstream KrF excimer laser, which has a wavelength of 248 nm, and one that uses an ArF excimer laser, which has a wavelength of 193 nm.

In addition, a liquid immersion method has been proposed as a different method that substantially shortens the wavelength of the exposure light (refer to Japanese Unexamined Patent Application, First Publication No. H10-303114, Japanese Unexamined Patent Application, First Publication No. H10-340846, Japanese Unexamined Patent Application, First Publication No. H11-176727, PCT International Publication No. 99/49504, and the like). This method improves the resolution and/or the depth of focus by making use of the fact that, if a liquid is filled between a lower surface of a projection optical system and a wafer, then the wavelength of the exposure light in the liquid is 1/n times that of in air (where "n" is the refractive index of the liquid, which is 1.2 to 1.7).

However, in a liquid immersion type exposure apparatus, there is a possibility that the immersion liquid will erode the lens at the front of the projection lens, thereby extremely reducing the life of the apparatus. In other words, in a liquid immersion type exposure apparatus in which the NA of the projection lens is large and short wavelength ultraviolet light is used as the exposure light, the energy of the light itself is extremely high, and the density of the light increases sharply at locations close to the image forming plane. Consequently, there is a possibility that the front lens, in which the high energy exposure light concentrates, will erode in a comparatively short period of time, thereby shortening the life of the projection lens, i.e., the liquid immersion type exposure apparatus.

In addition, there is also a possibility that impurities in the liquid will adhere to the surface of the lens at the front of the projection lens that contacts the liquid.

Here, it is conceivable to protect the projection lens by providing a replaceable parallel plane plate at the front of the projection lens; however, it is difficult to form an antireflection film appropriate to the parallel plane plate if the NA is large, which results in increased surface reflection at the parallel plane plate and image degradation due to flare and the like.

Therefore, it is an object of the present invention to provide a high performance liquid immersion type lens system that can be used stably for a long period of time, a projection exposure apparatus provided therewith, and a device fabricating method that uses the projection exposure apparatus.

### DISCLOSURE OF INVENTION

To solve the abovementioned problems, a liquid immersion type lens system according to the first invention includes: (a) an optical system main body that has an optical surface at one end along its optical axis and that is in a state wherein the optical surface contacts a first immersion liquid; (b) a light transmitting member that has two surfaces, one on each end along the optical axis, is disposed opposing the optical surface of the optical system main body, one of the two surfaces contacting the first immersion liquid, the other of the two surfaces contacting a second immersion liquid; and (c) a holding member that detachably supports the light transmitting member so that the one surface opposes the optical surface of the optical system main body.

According to the abovementioned liquid immersion type lens system, the light transmitting member is disposed opposing the optical surface of the optical system main body, and therefore the optical system main body is disposed spaced apart from the target, such as the workpiece (photosensitive substrate), which is disposed on the second immersion liquid side, through the light transmitting member. Thereby, it is possible to avoid damage to the optical system main body. In addition, although there is a possibility that the light transmitting member will be damaged by the second immersion liquid and the condensed processing light, or that impurities in the second immersion liquid will adhere to the light transmitting member, the performance of the liquid immersion type lens system can be maintained over the long term by replacing the light transmitting member with a new one.

In addition, in the abovementioned liquid immersion type lens system, the first immersion liquid is isolated from the second immersion liquid. Thereby, it is possible to prevent the problem of mixing the impurities and the like in the second immersion liquid into the first immersion liquid.

In addition, in the abovementioned liquid immersion type lens system, the first immersion liquid is reserved inside a closed space, a circumference of which is closed, and the second immersion liquid exists in an open space, a circumference of which is open. In this case, the openness of the second immersion liquid on the side of the target, such as the workpiece, increases work efficiency. Meanwhile, the first immersion liquid is more reliably isolated from the second immersion liquid by reserving in a closed space.

In addition, in the abovementioned liquid immersion type lens system, the amount of the first immersion liquid reserved in the closed space is greater than the amount of the second immersion liquid existing in the open space. In this case, the amount of the second immersion liquid is comparatively small, which shortens the time needed to fill or remove the second immersion liquid between the liquid immersion type lens system and the target, such as the workpiece, and further improves processing throughput.

In addition, in the abovementioned liquid immersion type lens system, the light transmitting member is parallel plane plate shaped. In this case, the displacement of the light transmitting member has little impact on imaging, and therefore the alignment accuracy of the light transmitting member tends not to become a problem, and the work efficiency of replacing the light transmitting member can be increased while maintaining image forming performance.

In addition, the abovementioned liquid immersion type lens system further includes a supply and recovery mechanism that supplies the second immersion liquid so that the second immersion liquid contacts the other of the two surfaces, and recovers the second immersion liquid, which contacts the other surface. In this case, it is possible to intermittently or continuously replace the second immersion liquid by supplying and recovering it with an appropriate timing.

In addition, the abovementioned liquid immersion type lens system further includes a circulation mechanism that circulates at least one of the first immersion liquid between the optical system main body and the light transmitting member; and the second immersion liquid, which contacts the other surface of the light transmitting member. In this case, the circulation mechanism can refresh the immersion liquid while uniformizing the composition and temperature of the immersion liquid.

In addition, in the abovementioned liquid immersion type lens system, the circulation mechanism includes a first circulation system that circulates the first immersion liquid, and a second circulation system that circulates the second immersion liquid. In this case, it is possible to independently circulate, by separate circulation systems, each immersion liquid while remaining isolated.

In addition, the abovementioned liquid immersion type lens system further includes a temperature adjustment apparatus that adjusts a temperature of at least one of the first and second immersion liquids. In this case, it is possible to prevent the acceleration of damage caused by heating, and/or characteristic fluctuations due to temperature changes in, for example, the light transmitting member and the optical system main body.

In addition, in the abovementioned liquid immersion type lens system, the first and second immersion liquids are both deionized water. In this case, there is little damage to the light transmitting member, the optical system main body, and the like, and the handling characteristics of deionized water as an immersion liquid are excellent. Furthermore, the water has a cleaning effect, which can prevent contamination of the liquid immersion type lens system; in addition, the water has excellent environmental performance, which simplifies the processing equipment as well as the postprocessing of waste and the like.

In addition, in the abovementioned liquid immersion type lens system, the light transmitting member is made of fluorite. In this case, the differential in the refractive index between the light transmitting member and the first immersion liquid (e.g., water) is small, which reduces reflection at the light transmitting member. Furthermore, if the fluorite protective member, i.e., the light transmitting member, becomes damaged, it should be replaced.

In addition, in the abovementioned liquid immersion type lens system, an optical element that constitutes the optical surface of the optical system main body is made of synthetic quartz. In this case, the optical element of the optical system main body is made of synthetic quartz, and it is therefore possible to reduce the damage to the optical element on the main body side due to the first immersion liquid.

In addition, in the abovementioned liquid immersion type lens system, the light transmitting member is made of fluorite; and the optical element that constitutes the optical surface of the optical system main body is made of synthetic quartz.

According to the abovementioned liquid immersion type lens system, the light transmitting member is fluorite, and it is therefore possible to reduce reflection at the replaceable light transmitting member, to prevent degradation of the image forming characteristics due to stray light, and to reduce the burden of the work of aligning the light transmitting member. In addition, because the optical element of the optical system main body is synthetic quartz, it is possible to reduce damage to the optical element on the main body side due to the first immersion liquid.

In addition, a projection exposure apparatus of the present invention is an apparatus that uses a projection optical system to projection expose a pattern image onto a substrate, including a liquid immersion type lens system, according to the abovementioned inventions, that forms the pattern image on the substrate.

The abovementioned projection exposure apparatus uses the liquid immersion type lens system, which is discussed above, as a projection lens system for forming the pattern image on the substrate, which enables liquid immersion type exposure and improves the resolution and/or the depth of focus. In this case, it is possible to avoid damage to the optical system main body of the liquid immersion type lens system due to the light transmitting member, and to maintain the performance of a projection exposure apparatus, to which the liquid immersion method is adapted, over a long time period.

In addition, the projection exposure apparatus of the present invention is a projection exposure apparatus that uses a projection optical system to projection expose a pattern image onto a substrate, wherein the projection optical system thereof includes: an optical system main body that has an optical surface at one end along its optical axis and that is in a state wherein the optical surface contacts a first immersion liquid; and a light transmitting member that includes two surfaces, one on each end along its optical axis, is disposed opposing the optical surface of the optical system main body, and is in a state wherein one of the two surfaces contacts the first immersion liquid, and the other of the two surfaces contacts a second immersion liquid.

According to the projection exposure apparatus of the present invention, the optical path between the projection optical system and the light transmitting member is filled with the first immersion liquid, and it is therefore possible to make the light transmitting member an optical element that has no, or extremely little, refractive power.

In addition, a device fabricating method of the present invention uses the abovementioned projection exposure apparatus to fabricate high performance devices.

### BRIEF DESCRIPTION OF THE DRAWINGS

FIG. 1 is a schematic block diagram of a projection exposure apparatus according to one embodiment of the present invention.
FIG. 2 is an enlarged view of a lower end portion of a liquid immersion type lens system that is incorporated in the projection exposure apparatus depicted in FIG. 1.
FIG. 3 is a flow chart that depicts one example of a process of fabricating a semiconductor device.

### BEST MODE FOR CARRYING OUT THE INVENTION

The following explains a step and repeat system projection exposure apparatus, which incorporates a liquid immersion type lens system according to the present invention.

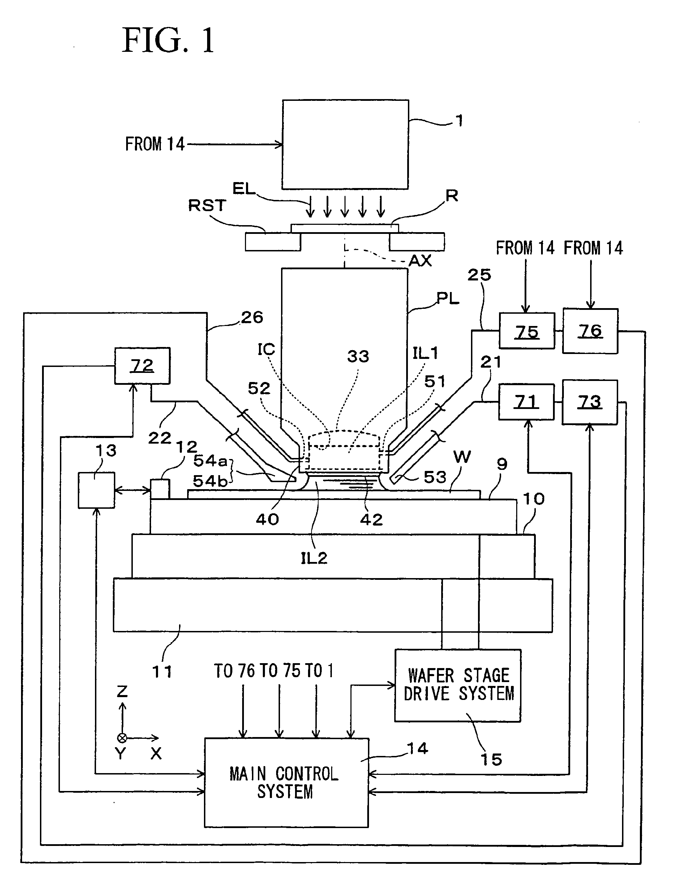

FIG. 1 is a schematic block diagram of the projection exposure apparatus of the present embodiment; in FIG. 1, a pattern provided to a reticle R is illuminated by an exposure light EL, which consists of ultraviolet pulsed light (193 nm wavelength) emitted from an illumination optical system 1 that includes an ArF excimer laser light source as an exposure light source, an optical integrator (homogenizer), a field stop, a condenser lens, and the like. The pattern of the reticle R is reduction-projected to an exposure area on the wafer W, which is coated with a photoresist, through a projection optical system PL that is telecentric on both sides (or on one side only, i.e., the side of the wafer W that is the work piece) at a prescribed projection magnification β (β is, for example, 1/4, 1/5). In the following explanation, the Z axis is parallel to the optical axis AX of the projection optical system PL, the Y axis is perpendicular to the paper surface of FIG. 1 within a plane perpendicular to the Z axis, and the X axis is parallel to the paper surface of FIG. 1.

The reticle R is held on a reticle stage RST, and a mechanism is incorporated therein that finely moves the reticle R in the X direction, the Y direction, and the rotational direction of each axis. A laser interferometer (not shown) measures the two dimensional position and the rotational angles of the reticle stage RST in real time, and a main control system 14 positions the reticle R based on these measured values.

Meanwhile, the wafer W is held on a Z stage 9, which controls the focus position (position in the Z direction) and the inclination angles of the wafer W, via a wafer holder (not shown). The Z stage 9 is fixed on an XY stage 10, which moves along the XY plane substantially parallel to the image plane of the projection optical system PL and is mounted on the base 11. The Z stage 9 controls the focus position (position in the Z direction) and the inclination angles of the wafer W, and aligns the upper surface thereof with the image plane of the projection optical system PL by using an autofocus system and an auto leveling system; additionally, the XY stage 10 positions the wafer W in the X direction and the Y direction. A laser interferometer 13 measures the two dimensional position and the rotational angles of the Z stage 9 (wafer W) in real time as the position of a movable mirror 12. Based on these measurement results, control information is sent from the main control system 14 to a wafer stage drive system 15, and, based thereon, the wafer stage drive system 15 controls the operation of the Z stage 9 and the XY stage 10. During exposure, an operation is performed repetitively by a step and repeat system, wherein each shot region on the wafer W is successively moved by a stepping motion to the exposure position and exposed with a pattern image of the reticle R.

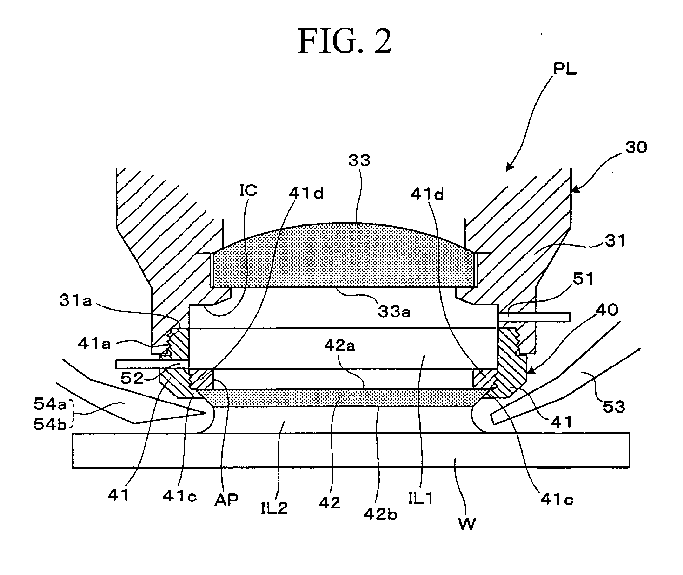

FIG. 2 is a side cross sectional view that explains the structure of a lower end part of the projection optical system PL. The projection optical system PL is a liquid immersion type lens system and is capable of substantially shortening the exposure light wavelength, enhancing the resolution, as well as substantially increasing the depth of focus. Furthermore, the projection optical system PL may be a refraction-type, reflective-type, or catadioptric-type system.

The projection optical system PL includes a main body portion 30 and an interchanging portion 40. The main body portion 30 is an optical system main body that includes a plurality of optical elements inside a lens barrel 31, and one of those optical elements, i.e., the optical element 33, is fixed to a lower end of the lens barrel 31 and externally exposed. The interchanging portion 40 is constituted by holding a plane parallel plate 42 to an annular holder 41, which is a holding member, and is attachable / detachable with respect to the main body portion 30. In other words, an annular female screw 31a is formed at the tip of the lower part of the lens barrel 31 of the main body portion 30, an annular male screw 41a is formed at the upper part of the holder 41, and the holder 41 can be fixed by screwing it to the lower end of the lens barrel 31. Conversely, the holder 41 can be detached from the lower end of the lens barrel 31 by unscrewing it, and can be exchanged with another holder (not shown) that has the same structure. Furthermore, the holder 41 has a circular aperture AP at a lower part thereof, the lower surface of the outer circumferential part of the plane parallel plate 42 is supported by an annular latching part 41 c, which is provided at the circumference of the aperture AP, and the upper surface of the outer circumferential part of the plane parallel plate 42 is supported by an annular fastening member 4 1 d, which is provided to the holder 41. Thereby, the plane parallel plate 42 is fixed so that only a prescribed amount thereof protrudes from the bottom surface of the holder 41.

In a state wherein the holder 41 is fixed by screwing it into the lower end of the lens barrel 31, an immersion liquid reservoir IC, which stores a first immersion liquid IL1, is formed between the holder 41 and the lens barrel 31. This immersion liquid reservoir IC, which forms a substantially closed space that has a disc shaped contour, is interposed between an emergent side optical surface 33a of the optical element 33 and an incident side flat surface 42a of the plane parallel plate 42. Furthermore, a second immersion liquid IL2 is held by its surface tension between the plane parallel plate 42 and the wafer W to be processed. In other words, the second immersion liquid IL2 is held in an open space.

One or more pairs, each pair including a delivery nozzle 51 and a suction nozzle 52, are formed in the immersion liquid reservoir IC, which reserves the first immersion liquid IL1, so that they are mutually opposing; the first immersion liquid IL1 is supplied to the immersion liquid reservoir IC; and thereby the space of the optical path of the exposure light between the emergent side optical surface 33a of the optical element 33 and the incident side flat surface 42a of the plane parallel plate 42 can be filled with the first immersion liquid IL 1; and the first immersion liquid IL1 in the immersion liquid reservoir IC can be gradually replaced. In other words, one or more delivery nozzles 51, which deliver a prescribed flow volume of the first immersion liquid IL1, are formed at an appropriate location on the side surface of the lower part of the lens barrel 31, and one or more suction nozzles 52, which discharge the first immersion liquid IL1, are formed at an appropriate location on the side surface of the holder 41. The number and arrangement of the delivery nozzles 51 and the suction nozzles 52 can be suitably modified in accordance with the usage conditions of the projection optical system PL, the size of the immersion liquid reservoir IC, the flow speed of the first immersion liquid IL1, the control temperature of the first immersion liquid IL1, and the like.

Furthermore, a delivery nozzle 53 of which the tip part is narrow, and a pair of suction nozzles 54a, 54b of which the tip parts are wide, are disposed mutually opposing at the circumference of the holder 41, the second immersion liquid IL2 is supplied to the open space that is interposed between an emergent side flat surface 42b of the plane parallel plate 42 and the surface of the wafer W, the space of the optical path of the exposure light between the emergent side flat surface 42b of the plane parallel plate 42 and the surface of the wafer W can be filled with the second immersion liquid IL2, the second immersion liquid IL2 can be removed from this open space, and thereby the second immersion liquid IL2 held in this open space can gradually be substituted or replaced.

The number and arrangement of the delivery nozzle 53 and the suction nozzles 54a, 54b can be suitably modified in accordance with the usage conditions of the projection optical system PL, the spacing between the plane parallel plate 42 and the wafer W, the movement of the wafer W, the flow speed of the second immersion liquid IL2, the control temperature of the second immersion liquid IL2, and the like.

Because the optical element 33 contacts the first immersion liquid IL1, the material of the optical element 33 must have corrosion resistance to the first immersion liquid IL1 in order to extend the life of the main body portion 30. Accordingly, instead of making the bulk material of the optical element 33 and the antireflection film from, for example, CaF₂ crystal, which is the traditional material, they are made of a light transmitting material that is less soluble in water than CaF₂ crystal material. Specifically, the optical element 33 is made of a bulk material consisting of, for example, synthetic quartz. Furthermore, an antireflection film consisting of magnesium fluoride can also be deposited on the bulk material if needed. Thereby, the optical element 33 that contacts the first immersion liquid IL1, i.e., the bulk material and the antireflection film, resists erosion, and the water resistance of the main body portion 30 can be increased; therefore, the image forming performance of the main body portion 30 can be maintained and, as a result, the image forming performance of the projection optical system PL can be satisfactorily maintained.

Meanwhile, the plane parallel plate 42 is preferably made of a material that has high corrosion resistance because it contacts both the first immersion liquid IL1 and the second immersion liquid IL2; however, it does not need to have a high corrosion resistance to both immersion liquids IL1, IL2 because the plane parallel plate 42 is an optical element that is interchangeable along with the holder 41. Accordingly, in the present embodiment, instead of making the bulk material and the like of the plane parallel plate 42 from a material that has a relatively low solubility in water, such as synthetic quartz, it is made of a light transmitting material that has a high solubility in water to a certain extent. However, because the exposure light concentrates and increases in light density at the plane parallel plate 42 and the vicinity thereof, it is preferable that the material of the plane parallel plate 42 is resistant to laser compaction to a certain extent. Specifically, the plane parallel plate 42 is formed using a bulk material consisting of CaF₂ crystals or the like. Furthermore, if needed, the plane parallel plate 42 is finished by depositing an antireflection film, which consists of magnesium fluoride (MgF₂), on the emergent surface of the bulk material. Of course, an antireflection film made of, for example, magnesium fluoride (MgF₂) may be provided on the incident surface of the plane parallel plate 42 that contacts the first immersion liquid IL 1.

Furthermore, the holder 41 and the lower end part of the lens barrel 31, which are for forming the container shaped immersion liquid reservoir IC, contact the first immersion liquid IL1 and therefore are made of a material that has a high corrosion resistance to the first immersion liquid IL1. In the present embodiment, deionized water (pure water) is used as the first immersion liquid IL1, and therefore the holder 41 and the lower end part of the lens barrel 31 are specifically formed by fabricating a titanium alloy, stainless steel, or the like.

In the projection optical system PL of the type discussed above, the image light, which transmitted through the reticle R (refer to FIG. 1) and impinged upon the upper end of the main body portion 30, converges and emerges from the optical element 33 provided to the lower end of the main body portion 30, and impinges upon the plane parallel plate 42 through the first immersion liquid IL1. The image light that passes through the plane parallel plate 42 is incident upon the wafer W through the second immersion liquid IL2 and forms a projected image.

Returning to FIG. 1; the first immersion liquid IL1, which is provided in the space, i.e., the immersion liquid reservoir IC, between the optical element 33 and the plane parallel plate 42, is supplied by a liquid supply apparatus 75, which includes a tank of that liquid, a pressure pump, and the like, through the delivery nozzle 51 in a state wherein the flow volume is controlled. A temperature adjustment apparatus 76, which is a temperature adjusting means, is provided on the upstream side of the liquid supply apparatus 75. Namely, the first immersion liquid IL1, which is fed from the liquid supply apparatus 75, is, for example, cooled to a desired temperature by the temperature adjustment apparatus 76. Here, the first immersion liquid IL1 is set to a temperature, for example, approximately the same as that inside a chamber wherein the projection exposure apparatus of the present embodiment is housed. Thus, by using the temperature adjustment apparatus 76 to maintain the first immersion liquid IL1 at a constant temperature, it is possible to stabilize the image forming characteristics of the projection optical system PL. At this time, the first immersion liquid IL1, the temperature of which is controlled by the temperature adjustment apparatus 76, cools the optical element 33 and the surface of the plane parallel plate 42, which are heated by the exposure light EL, and it is therefore possible to suppress the advance of the corrosion of these optical elements.

A supply pipe 25 extends from the liquid supply apparatus 75, connects to the lower end of the projection optical system PL, and communicates with the immersion liquid reservoir IC through the delivery nozzle 51.

Meanwhile, the suction nozzle 52, which communicates with the immersion liquid reservoir IC, is formed in the vicinity of the lower end of the projection optical system PL, and extends to the temperature adjustment apparatus 76 via a recovery pipe 26. The delivery nozzle 51 and the suction nozzle 52 are disposed so that they sandwich a lower end portion of the projection optical system PL, for example, in the X direction, and a flow of the first immersion liquid IL1 can be formed in the -X direction between the optical element 33 and the plane parallel plate 42, i.e., in the immersion liquid reservoir IC. The delivery nozzle 51, the suction nozzle 52, and the liquid supply apparatus 75 constitute at least part of a supply and recovery mechanism, and the delivery nozzle 51, the suction nozzle 52, the liquid supply apparatus 75, the supply pipe 25 and the recovery pipe 26 constitutes part of a circulation mechanism, which constitutes a first circulation system.

Furthermore, the temperature of the first immersion liquid IL1 does not necessarily need to be set to a temperature approximately the same as that inside the chamber, and the temperature adjustment apparatus 76 can control that temperature so that it is a desired temperature at which the image forming performance of the projection optical system PL can be maintained.

In addition, in the present embodiment, a circulation system is formed that returns the first immersion liquid IL1, which was recovered by the suction nozzle 52, to the temperature adjustment apparatus 76, but at least some of the first immersion liquid IL1 recovered from the suction nozzle 52 may be discarded, and new, clean first immersion liquid IL1 may be supplied to the temperature adjustment apparatus 76.

In addition, the temperature adjustment apparatus 76 can also be disposed on the downstream side of the liquid supply apparatus 75.

In addition, the temperature adjustment apparatus 76 and the pump and tank of the liquid supply apparatus 75 do not necessarily need to be provided to the projection exposure apparatus, and at least a part thereof can be substituted by the facilities in, for example, the plant where the projection exposure apparatus is installed.

The second immersion liquid IL2, which is interposed between the plane parallel plate 42 and the wafer W, is supplied by a liquid supply apparatus 71, which includes a tank of that liquid, a pressure pump, and the like, through the delivery nozzle 53 onto the wafer W in a state wherein the flow volume is controlled, and recovered by a liquid recovery apparatus 72, which includes a tank for the liquid, a suction pump, and the like, from the surface of the wafer W through a prescribed suction nozzle and the like. A temperature adjustment apparatus 73, which is a temperature adjusting means, is provided in the circulation passage from the liquid recovery apparatus 72 to the liquid supply apparatus 71. Namely, the second immersion liquid IL2, which is recovered by the liquid recovery apparatus 72, is returned to the liquid supply apparatus 71 in a state wherein the second immersion liquid IL2 is, for example, cooled to a desired temperature by the temperature adjustment apparatus 73. Here, the second immersion liquid IL2 is set to a temperature, for example, approximately the same as that inside the chamber that houses the projection exposure apparatus of the present embodiment. Thus, by using the temperature adjustment apparatus 73 to maintain the second immersion liquid IL2 at a constant temperature, it is possible to stabilize the image forming characteristics of the projection optical system PL. At this time, it is possible to suppress the advance of the erosion of the plane parallel plate 42 because the second immersion liquid IL2, the temperature of which is adjusted by the temperature adjustment apparatus 73, cools the surface of the plane parallel plate 42, which is heated by the exposure light EL.

The delivery nozzle 53 of which the tip part is narrow, extends from the liquid supply apparatus 71 via a supply pipe 21, and two suction nozzles 54a, 54b of which the tip parts are wide, extend from the liquid recovery apparatus 72 through a recovery pipe 22. The delivery nozzle 53 and the pair of suction nozzles 54a, 54b are disposed so that they sandwich the lower end portion of the projection optical system PL in the X direction, and a flow of the second immersion liquid IL2 can be formed in the -X direction between the plane parallel plate 42, which is provided to the interchanging portion 40, and the wafer W. Furthermore, although omitted from the drawing, a delivery nozzle is formed between and parallel to the pair of suction nozzles 54a, 54b, a pair of suction nozzles is formed so that one is on each side of the delivery nozzle 53 and is parallel thereto, and the flow of the second immersion liquid IL2 can thereby be switched to the +X direction. Furthermore, although omitted from the drawing, a second supply and delivery nozzle system is also provided at a position obtained by rotating, by substantially 90°, the position of the first supply and delivery nozzle system, which includes one set that includes the delivery nozzle 53, the suction nozzles 54a, 54b, and the like, about the lower end portion of the projection optical system PL, and a flow of the second immersion liquid IL2 can thereby be formed in the -Y or the +Y directions between the plane parallel plate 42 and the wafer W. In other words, when performing a step movement of the wafer W in the ±X direction at the time of exposure, a stable, laminar flow of the second immersion liquid IL2 can be formed between the plane parallel plate 42 and the wafer W using the first supply and delivery nozzle system; when performing a step movement of the wafer W in the ±Y direction at the time of exposure, a stable, laminar flow of the second immersion liquid IL2 can be formed between the plane parallel plate 42 and the wafer W using the second supply and delivery nozzle system; therefore, it is possible to always stably fill the space between the plane parallel plate 42 and the wafer W with fresh second immersion liquid IL2. Furthermore, the arrangement and operation of the delivery nozzles and the suction nozzles are disclosed in, for example, PCT International Publication No. WO99/49504, which is hereby incorporated by reference in its entirety to the extent permitted by the national laws and regulations of the designated states (or elected states) designated by the present international patent application.

In the above discussion, the delivery nozzle 53, the suction nozzles 54a, 54b, the liquid supply apparatus 71, the liquid recovery apparatus 72, and the temperature adjustment apparatus 73 constitute at least part of the supply and recovery mechanism, and the delivery nozzle 53, the suction nozzles 54a, 54b, the liquid supply apparatus 71, the liquid recovery apparatus 72, the temperature adjustment apparatus 73, the supply pipe 21 and the recovery pipe 22 constitutes the circulation mechanism, which constitutes at least part of a second circulation system.

Furthermore, the temperature of the second immersion liquid IL2 does not necessarily need to be set to a temperature approximately the same as that inside the chamber, and the temperature adjustment apparatus 73 can control that temperature so that it is a desired temperature at which the image forming performance of the projection optical system PL can be maintained.

In addition, in the present embodiment, a circulation system is formed that returns the second immersion liquid IL2, which was recovered by the suction nozzles 54a, 54b, to the temperature adjustment apparatus 73, but at least some of the second immersion liquid IL2 recovered from the suction nozzles 54a, 54b may be discarded, and new, clean second immersion liquid IL2 may be supplied to the temperature adjustment apparatus 73.

In addition, the temperature adjustment apparatus 73 can also be disposed on the downstream side of the liquid supply apparatus 71.

In addition, the pumps and tanks of both the liquid supply apparatus 71 and the liquid recovery apparatus 72, as well as the temperature adjustment apparatus 73, do not necessarily need to be provided to the projection exposure apparatus, and at least a part thereof can be substituted by the facilities in, for example, the plant where the projection exposure apparatus is installed.

In addition, if the temperatures of the first immersion liquid IL1 and the second immersion liquid IL2 are controlled so that they are the same, then a single temperature adjustment apparatus may be used for controlling the temperatures of the first immersion liquid IL1 and the second immersion liquid IL2.

The following explains a specific embodiment. A plano-convex lens of the optical element 33 is made of synthetic quartz, and the plane parallel plate 42 is made of fluorite. Furthermore, the thickness of the plane parallel plate 42 is 10 mm, the spacing between the optical element 33 and the plane parallel plate 42 is 2 mm, and the spacing between the plane parallel plate 42 and the wafer W is 5 mm. In addition, the image forming side NA of the projection optical system PL is 1.25. In addition, the first and second immersion liquids IL1, IL2 are deionized water (pure water). Deionized water has an advantage in that a large quantity of it can be easily obtained at semiconductor fabrication plants and the like, and it does not adversely affect the optical lenses, the photoresist of the wafer W, and the like. In addition, deionized water does not adversely impact the environment, has an extremely low content of impurities, and can also be expected to serve the function of cleaning the surface of the wafer. Furthermore, because the refractive index n of deionized water (water) with respect to the exposure light EL, which has a wavelength of approximately 200 nm, is substantially 1.44, the 193 nm wavelength of the ArF excimer laser light is shortened on the wafer W by 1/n, i.e., to approximately 134 nm, and thereby high resolution can be achieved. Furthermore, because the depth of focus increases by approximately n times, i.e., approximately 1.44 times, compared with that of in air, the numerical aperture of the projection optical system PL can be further increased if it is preferable to ensure a depth of focus on the same order as that when used in air, and the resolution improves from this standpoint as well.

The energy density at the emergent side optical surface 33a of the optical element 33 is 1.5% of the energy density at the emergent side flat surface 42b of the plane parallel plate 42, and is 3% of the energy density at the incident side flat surface 42a of the plane parallel plate 42. In other words, compared with the energy density at the position of the plane parallel plate 42, the energy density at the emergent side optical surface 33a of the optical element 33 is two orders of magnitude smaller, and therefore the erosion of the optical element 33 due to the second immersion liquid IL2, laser compaction due to the exposure light EL, and the like are at levels that can be ignored.

At the emergent side optical surface 33a of the optical element 33 and the emergent side flat surface 42b of the plane parallel plate 42, the reflectance along the optical axis are 0.14% and 0.03%, respectively, and the reflectance along the optical axis with respect to the incident angle (60°) corresponding to their maximum NAs are 0.87% and 0.32% (the average of the S polarized light and the P polarized light), respectively. In other words, if the angle of incidence of the light ray of the exposure light EL is 0° to 60°, then the reflectance at the intermediate emergent side optical surface 33a and the final emergent side flat surface 42b is an extremely low 0.14 to 0.87% or 0.03 to 0.32%, and therefore a reflectance value that is not possible with an antireflection film can be easily achieved.

The following explains the operation of the projection exposure apparatus depicted in FIG. 1 and the like. The liquid supply apparatus 75 and the like are actuated in advance, and the first immersion liquid IL1, which has a constant temperature, is circulated in the immersion liquid reservoir IC of the projection optical system PL. Next, by appropriately driving the Z stage 9 and the XY stage 10, the projection optical system PL is positioned to an appropriate location with respect to the wafer W. At this time, the liquid supply apparatus 71, the liquid recovery apparatus 72, and the like are actuated, and the second immersion liquid IL2, which has a constant temperature, is circulated between the wafer W and the plane parallel plate 42. Meanwhile, the reticle R, wherein the pattern is formed, is superimposingly and uniformly illuminated by the exposure light EL that emerges from the illumination optical system 1. A light beam, which transmits through the pattern of the reticle R, passes through the projection optical system PL and forms an image of the mask pattern on the wafer W, which is a photosensitive substrate. Furthermore, the entire surface of the wafer W is sequentially exposed with the desired pattern by performing a step movement of the wafer W within the XY plane orthogonal to the optical axis AX of the projection optical system PL. At this time, because the optical element 33, which is provided at the lower end of the main body portion 30 of the projection optical system PL, is disposed so that it is spaced apart from the wafer W, it is possible to avoid damaging the main body portion 30 due to the exposure light EL and the first immersion liquid IL1. Furthermore, the performance of the projection optical system PL can be maintained for a long period of time because the plane parallel plate 42, which might be damaged by the exposure light EL, the second immersion liquid IL2, and the like, can be replaced with a new one along with the interchanging portion 40. In addition, because the space between the optical element 33 and the plane parallel plate 42 is filled with a first immersion liquid IL1, which has a refractive index that is close to that of the optical element 33 and the plane parallel plate 42, it is possible to prevent reflection at the emergent side optical surface 33a of the optical element 33 and the incident side flat surface 42a of the plane parallel plate 42, as well as degradation of the image forming characteristics, e.g., flare. Furthermore, because the space between the plane parallel plate 42 and the wafer W can be filled during exposure with a comparatively small amount of the second immersion liquid IL2 (compared with the first immersion liquid IL1 in the immersion liquid reservoir IC), the amount of the second immersion liquid IL2 used is reduced, the operation of supplying the second immersion liquid IL2 can be performed efficiently and rapidly, and the speed of the exposure process can be increased.

Furthermore, the amount of the first immersion liquid IL1 between the optical element 33 and the plane parallel plate 42 may differ from the amount of the second immersion liquid IL2 between the plane parallel plate 42 and the wafer W, or it may be the same. In addition, the flow speed (or flow rate) of the first immersion liquid IL1 between the optical element 33 and the plane parallel plate 42 may differ from the flow speed of the second immersion liquid IL2 between the plane parallel plate 42 and the wafer W, or it may be the same.

Furthermore, because the first immersion liquid IL1 is relatively spaced apart from the image plane of the projection optical system PL, the change in the temperature of the first immersion liquid IL1 due to its irradiation by the exposure light EL is small compared with the second immersion liquid IL2, the adverse affect of the change in temperature of the first immersion liquid IL1 upon the image forming performance of the projection optical system PL is quite small compared with the second immersion liquid IL2, and the first immersion liquid IL1 is exceptionally resistant to contamination compared with the second immersion liquid IL, which contacts the wafer W; therefore, the required amount of the first immersion liquid IL1 is smaller than that of the second immersion liquid IL2, and the required flow speed (speed of replacing the immersion liquid) of the first immersion liquid IL1 may be smaller than the second immersion liquid. Accordingly, the operation of supplying the first immersion liquid IL1 by the delivery nozzle 51, and the operation of recovering the first immersion liquid IL2 by the suction nozzle 52 may be stopped during the projection of the pattern image onto the wafer W.

The above explained the present invention according to the embodiments, but the present invention is not limited to the abovementioned embodiments. For example, in addition to pure water, it is also possible to use a liquid as the first and second immersion liquids IL1, IL2 that has sufficient transmittance with respect to the exposure light EL, has as high a refractive index as possible, and is stable with respect to the projection optical system PL and to the photoresist coated on the surface of the wafer W. For example, it would be suitable to use a fluorine based immersion liquid as the liquid, which transmits the exposure light EL of which the wavelength is less than 200 nm, that includes, for example, fluorine based oil (Fluorinert made by U.S. based 3M) and perfluorinated polyether (PFPE).

In addition, in the embodiments discussed above, pure water (deionized water) is used for both the first immersion liquid IL1 and the second immersion liquid IL2, but the water quality thereof (such as control temperature, temperature stability, dissolved oxygen concentration, specific resistance value, total organic carbon (TOC)) may differ. For example, the water quality of the second immersion liquid IL2 can be higher than the water quality of the first immersion liquid IL1. In addition, different types of liquids (including aqueous solutions) may be used for the first immersion liquid IL1 and the second immersion liquid IL2.

In addition, the exposure light EL is not limited to ArF excimer laser light; instead, KrF excimer laser light (248 nm wavelength), F₂ laser light (157 nm wavelength), i line (365 nm wavelength) of a mercury lamp, and the like, may be used. For example, if KrF excimer laser light is used, then synthetic quartz, fluorite, or the like can be used as the main body material of the optical element 33, and magnesium fluoride (MgF₂) or the like can be used as the material for the antireflection film thereof. At this time, fluorite, for example, can be used as the main body material of the plane parallel plate 42, but synthetic quartz can also be used because it tends not to suffer from the problem of laser compaction at relatively short wavelengths. In addition, if using F₂ laser light, then fluorite, for example, can be used as the main body material of the optical element 33, and magnesium fluoride, for example, can be used as the material of the antireflection film thereof. At this time, fluorite, for example, can be used as the main body material of the plane parallel plate 42.

In addition, the material of the antireflection film of the optical element 33 is not limited to magnesium fluoride, and it is possible to use fluorides, such as lanthanum fluoride, gadolinium fluoride, neodymium fluoride, yttrium fluoride, LiSrAlF₆, and LiCaAlF₆, as well as to use oxides, such as sapphire and crystals; furthermore, it is also possible to form a multilayer structure by appropriately combining films of these materials.

In addition, in the embodiments discussed above, the parallel plane plate is used as the optical element of the interchanging portion 40 of the projection optical system PL, but, for example, it may be a lens that has an extremely small refractive index. In addition, the optical element 33 of the projection optical system PL is a plano-convex lens, wherein the optical surface 33a is a flat surface, but it is also possible to use a lens wherein the optical surface 33a is a curved surface.

In addition, in the embodiments discussed above, the step and repeat system projection exposure apparatus may be a static exposure type, which exposes one shot region on the wafer W in a state wherein the wafer W is substantially stationary, but may also be a scanning exposure type, wherein the wafer W is exposed while moving.

In addition, in the embodiments discussed above, an exposure apparatus is adopted that locally fills the space between the projection optical system PL and the wafer W with the second immersion liquid IL2, but the present invention may also be adapted to a liquid immersion exposure apparatus that moves a stage, which holds the substrate to be exposed, in a liquid bath, as disclosed in Japanese Unexamined Patent Application, First Publication No. H06-124873, as well as to a liquid immersion exposure apparatus that forms a liquid bath that has a prescribed depth on the stage and holds the substrate therein, as disclosed in Japanese Unexamined Patent Application, First Publication No. H10-303114.

Furthermore, in the abovementioned embodiments, in addition to the nozzles for supplying and recovering the second immersion liquid IL2 from the X direction and the Y direction, nozzles may be provided, for example, for supplying and recovering the second immersion liquid IL2 from a diagonal direction.

In addition, the present invention may also be adapted to a twin stage type exposure apparatus that includes two stages, which separately load substrates to be processed, such as wafers, and are independently movable in the X and Y directions. The structure and the exposure operation of a twin stage type exposure apparatus is disclosed in, for example, Japanese Unexamined Patent Application, First Publication No. H10-163099 and Japanese Unexamined Patent Application, First Publication No. H10-214783 (corresponding U.S. Patent Nos. 6,341,007, 6,400,441, 6,549,269, and 6,590,634), Published Japanese Translation No. 2000-505958 of the PCT International Publication (corresponding U.S. Patent No. 5,969,441), or U.S. Patent No. 6,208,407, and these disclosures are each hereby incorporated by reference in its entirety to the extent permitted by the national laws and regulations of the designated states (or elected states) designated by the present international patent application.

In addition, as disclosed in Japanese Unexamined Patent Application, First Publication No. H11-135400, the present invention can also be adapted to an exposure apparatus that includes an exposure stage, which can hold and move a substrate to be processed, such as a wafer, and a measurement stage having various measuring members and sensors.

According to the embodiments discussed above, a light transmissive plane parallel plate 42 is disposed opposing the optical surface 33a of the optical system main body 30, and therefore the optical system main body 30 is disposed spaced apart from the target workpiece, such as the wafer W, which is disposed on the second immersion liquid side, through the plane parallel plate 42. Thereby, the plane parallel plate 42 functions as if to protect the optical system main body 30, making it possible to avoid damage to the optical system main body 30 due to the immersion liquid and the exposure light, which condenses on the plane parallel plate 42 side. In addition, although there is a possibility that the plane parallel plate 42 will be damaged by the second immersion liquid IL2 and the condensed exposure light, or that impurities in the second immersion liquid IL2 will adhere to the plane parallel plate 42, the performance of the liquid immersion type lens system can be maintained over the long term by replacing the plane parallel plate 42 with a new one. In addition, because the first immersion liquid IL1, which has a refractive index higher than that of air, is disposed between the plane parallel plate 42 and the optical surface 33a of the optical system main body 30 (optical element 33), it is possible not only to maintain the high optical performance of the immersion optical system, even if the plane parallel plate 42 is disposed, but also to prevent reflection at one surface of the plane parallel plate 42 and the like, as well as degradation of the image forming characteristics due to, for example, flare.

In addition, because the first immersion liquid IL1 and the second immersion liquid IL2 are isolated, it is possible to prevent the problem of the mixing of impurities, and the like, in the second immersion liquid IL2 into the first immersion liquid IL1. In addition, because the first immersion liquid IL1 and the second immersion liquid IL2 are isolated, the exposure process and the like can be performed efficiently by intermittently supplying or continuously refreshing the second immersion liquid IL2 separately from the first immersion liquid IL1, which leads to an improvement in throughput.

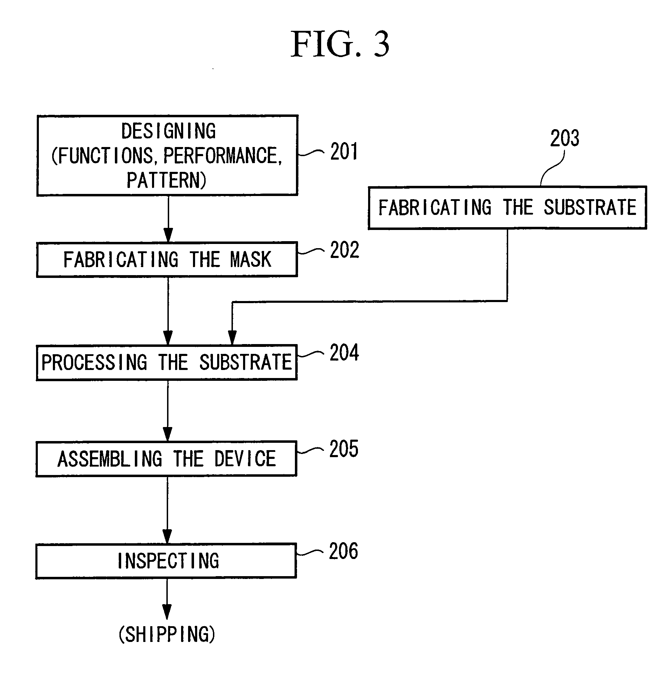

As shown in FIG. 3, a microdevice, such as a semiconductor device, is manufactured by: a step 201 that designs the functions and performance of the microdevice; a step 202 that fabricates a mask (reticle) based on the design step; a step 203 that fabricates a substrate (wafer), which is the base material of the device; an exposure processing step 204 wherein the exposure apparatus of the embodiments discussed above exposes a pattern of the mask onto the substrate; a device assembling step 205 (including the dicing process, bonding process, and packaging process); an inspecting step 206; and the like.

## Claims

1. A liquid immersion type lens system, comprising:
an optical system main body that has an optical surface at one end along an optical axis, the optical surface contacting a first immersion liquid;
a light transmitting member that has two surfaces, one on each end along the optical axis, is disposed opposing the optical surface of the optical system main body, one of the two surfaces contacting the first immersion liquid, the other of the two surfaces contacting a second immersion liquid; and
a holding member that detachably supports the light transmitting member so that the one surface opposes the optical surface of the optical system main body.

2. A liquid immersion type lens system according to Claim 1, wherein the first and second immersion liquids each include water.

3. A liquid immersion type lens system according to Claim 1, wherein the first immersion liquid is isolated from the second immersion liquid.

4. A liquid immersion type lens system according to Claim 3, wherein
the first immersion liquid is reserved inside a closed space, a circumference of which is closed; and
the second immersion liquid exists in an open space, a circumference of which is open.

5. A liquid immersion type lens system according to Claim 4, wherein the amount of the first immersion liquid reserved in the closed space is greater than the amount of the second immersion liquid existing in the open space.

6. A liquid immersion type lens system according to Claim 1, wherein the light transmitting member is parallel plane plate shaped.

7. A liquid immersion type lens system according to Claim 1, further comprising:
a supply and recovery mechanism that supplies the second immersion liquid so that the second immersion liquid contacts the other of the two surfaces, and recovers the second immersion liquid, which contacts the other surface.

8. A liquid immersion type lens system according to Claim 1, further comprising:
a circulation mechanism that circulates at least one of the first immersion liquid between the optical system main body and the light transmitting member; and the second immersion liquid, which contacts the other surface of the light transmitting member.

9. A liquid immersion type lens system according to Claim 8, wherein the circulation mechanism includes a first circulation system that circulates the first immersion liquid, and a second circulation system that circulates the second immersion liquid.

10. A liquid immersion type lens system according to any one of Claims 1 to 8, further comprising:
a temperature adjustment device that adjusts a temperature of at least one of the first and second immersion liquids.

11. A liquid immersion type lens system according to Claim 1, wherein the first and second immersion liquids are both deionized water.

12. A liquid immersion type lens system according to Claim 1, wherein the light transmitting member is made of fluorite.

13. A liquid immersion type lens system according to Claim 1, wherein an optical element that constitutes the optical surface of the optical system main body is made of synthetic quartz.

14. A liquid immersion type lens system according to Claim 1, wherein an optical element, which constitutes the optical system main body, and the light transmitting member transmit ultraviolet light for projection exposure.

15. A liquid immersion type lens system according to Claim 14, wherein the ultraviolet light is one of ArF excimer laser light, KrF excimer laser light, F₂ laser light, and i line of a mercury lamp.

16. A liquid immersion type lens system according to Claim 1, wherein at least one of an optical element that constitutes the optical system main body and the light transmitting member has an antireflection film.

17. A liquid immersion type lens system according to Claim 1, wherein
the light transmitting member is made of fluorite; and
an optical element that constitutes the optical surface of the optical system main body is made of synthetic quartz.

18. A liquid immersion type lens system according to Claim 17, wherein the first and second immersion liquids each include water.

19. A projection exposure apparatus that uses a projection optical system to projection expose a pattern image onto a substrate, comprising:
a liquid immersion type lens system, according to Claim 1, that forms the pattern image on the substrate.

20. A projection exposure apparatus that uses a projection optical system to projection expose a pattern image onto a substrate, wherein
the projection optical system includes:
an optical system main body that has an optical surface at one end along an optical axis, the optical surface contacting a first immersion liquid; and
a light transmitting member that has two surfaces, one on each end along the optical axis, is disposed opposing the optical surface of the optical system main body, one of the two surfaces contacting the first immersion liquid, the other of the two surfaces contacting a second immersion liquid.

21. A projection exposure apparatus according to Claim 20, wherein the light transmitting member is detachable.

22. A projection exposure apparatus according to Claim 21, wherein the light transmitting member is parallel plane plate shaped.

23. A projection exposure apparatus according to Claim 20, wherein
an immersion area is locally formed with the second immersion liquid on the substrate; and
the substrate is exposed through the first and second immersion liquids.

24. A projection exposure apparatus according to Claim 20, wherein the first and second immersion liquids each include water.

25. A projection exposure apparatus according to Claim 20, wherein the first immersion liquid is isolated from the second immersion liquid.

26. A projection exposure apparatus according to Claim 25, further comprising:
a first supply and recovery mechanism that supplies the first immersion liquid and recovers the first immersion liquid.

27. A_projection exposure apparatus according to Claim 26, further comprising:
a temperature adjustment apparatus that adjusts a temperature of the first immersion liquid.

28. A projection exposure apparatus according to Claim 27, wherein the first supply and recovery mechanism includes a circulation system of the first immersion liquid.

29. A projection exposure apparatus according to Claim 26, further comprising:
a second supply and recovery mechanism that supplies the second immersion liquid and recovers the second immersion liquid.

30. A projection exposure apparatus according to Claim 29, comprising:
a temperature adjustment apparatus that adjusts the temperature of the second immersion liquid.

31. A projection exposure apparatus according to Claim 30, wherein the second supply and recovery mechanism includes a circulation system of the second immersion liquid.

32. A device fabricating method that uses a projection exposure apparatus as recited in Claim 19 or 20.
